# EUROPEAN PATENT SPECIFICATION

(11) **EP 2 991 105 B1**
(45) Date of publication and mention of the grant of the patent: **30.09.2020**
(21) Application number: 14787718.7
(22) Date of filing: 28.04.2014
(51) Int. Cl.: H01L 23/373, B32B 15/01, H01L 23/15, H05K 1/03, H05K 1/09, H05K 3/38, C04B 37/02, B23K 35/30, B32B 7/02, B32B 7/12, B32B 9/00, B32B 9/04, B32B 15/04, B32B 15/20, B32B 3/26

(54) **COMPOSITE LAMINATE AND ELECTRONIC DEVICE**
VERBUNDLAMINAT UND ELEKTRONISCHE VORRICHTUNG
STRATIFIÉ COMPOSITE ET DISPOSITIF ÉLECTRONIQUE

(30) Priority: 26.04.2013 JP 2013094035
(43) Date of publication of application: 02.03.2016
(73) Proprietor: Kyocera Corporation, Fushimi-ku Kyoto-shi Kyoto 612-8501 (JP)
(72) Inventor: NIINO,Noritaka, Kyoto-shi Kyoto 612-8501 (JP)
(74) Representative: Viering, Jentschura & Partner mbB Patent- und Rechtsanwälte
(86) International application number: PCT/JP2014/061916
(87) International publication number: WO 2014/175459

(56) References cited:
- WO-A1-2011/034075
- WO-A1-2013/024829
- WO-A1-2014/054609
- JP-A- H0 529 507
- JP-A- H05 294 744
- JP-A- H06 321 649
- JP-A- S57 107 501
- JP-A- 2003 163 384
- JP-A- 2012 115 846
- JP-A- 2013 027 918
- US-A- 5 561 321
- US-A- 5 900 673
- US-A1- 2012 168 209

## Description

### TECHNICAL FIELD

The present invention relates to a composite laminate and an electronic device.

### BACKGROUND

An electronic device in which electronic elements are mounted on a composite laminate is used, for example, as an insulated gate bipolar transistor (IGBT), such as a power module, or a switching module. In the composite laminate, for example, a joint body in which a metal layer made from copper is brazed to a ceramic substrate is used. The electronic element is mounted to the metal layer, and is electrically connected to the metal layer using a bonding wire, for example.

### PRIOR ART DOCUMENTS

### Patent Documents

Patent Document 1: Japanese Unexamined Patent Application No. H4-149075A

US5561321 relates to the joining of a Cu layer to a ceramic substrate. The thermal expansion of the metallic body that is joined to the ceramic is relaxed by a metallic layer. The metallic body is Cu. The metallic layer is made at least partially from Mo or W. The joining material is an Ag-Cu alloy.

JPH0529507 mentions that an Mo plate is inserted in between an AlN substrate and a Cu plate in order to restrain the thermal expansion of the Cu plate. The brazing material can be Ag-based or Ti-based.

US5900673 discloses a semiconductor device that contains a metallised ceramic substrate that is joined through brazing with a heat sink. The heat sink can be made of copper, the ceramic can be mullite and the metallisation tungsten. The metallisation can also be Mo. The brazing compositions can contain 20-40 wt% of Sn, 20-40 wt% of In/Sb and 30-50 wt% of Ag.

### SUMMARY OF THE INVENTION

### Problems to be Solved by the Invention

However, in the composite laminate of the aforementioned conventional art, the problem is that there is a likelihood of the brazing material peeling from the metal layer and/or cracks forming in the brazing material as a result of thermal stress caused by the difference in the coefficient of thermal expansion between the metal layer and the ceramic substrate.

### Means to Solve the Problem

The present invention provides a composite laminate according to claim 1, and an electronic device according to claim 4. 5 . Further embodiments of the invention are described in the dependent claims.

### EFFECT OF THE INVENTION

According to the composite laminate according to claim 1, a substantial anchor effect can be achieved between the second metal layer and the third metal layer because the third metal layer includes the metal portion that partially penetrates the second metal layer from the third metal layer. Thus, internal inter-layer peeling can be suppressed because the third metal layer is firmly jointed to the first metal layer.

According to the electronic device according to the present invention, inter-layer peeling can be suppressed because the electronic device has the composite laminate of the above-described configuration.

### BRIEF DESCRIPTION OF THE DRAWING(S)

FIG. 1 is a cross-sectional view illustrating a composite laminate and an electronic device of a first embodiment of the present invention.
FIG. 2 is an enlarged view of portion A of FIG. 1.
FIG. 3 is a cross-sectional view illustrating a composite laminate of a second embodiment of the present invention.
FIG. 4 is a cross-sectional view illustrating a modification example of the composite laminate of FIG. 3, and an electronic device having this composite laminate.
FIG. 5 is a cross-sectional view illustrating a modification example of the composite laminate and electronic device of FIG. 4.
FIG. 6 is a cross-sectional view illustrating a composite laminate and an electronic device of a third embodiment of the present invention.
FIG. 7 is an enlarged view illustrating portion A of FIG. 6.
FIG. 8 is an enlarged view illustrating a modification example of portion A of FIG. 6.

### BEST MODE FOR CARRYING OUT THE INVENTION

A number of embodiments illustrative of the present invention will be explained below by referring to the drawings. Furthermore, in the drawings below, a composite laminate and an electronic device are disposed inside a hypothetical xyz space, and are placed on the xy plane. In addition, the upwards direction in the embodiments is the normal direction of a hypothetical z axis.

### First embodiment (not according to the invention)

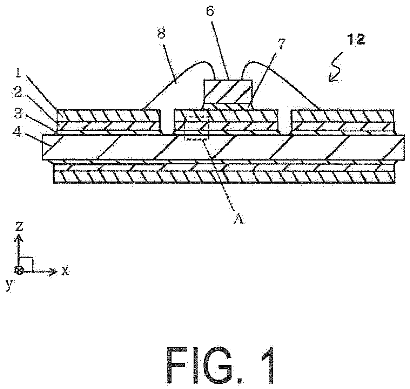

As in the example illustrated in FIG. 1, a composite laminate 12 according to this embodiment includes a first metal layer 1, a second metal layer 2, a third metal layer 3, and a fourth layer 4. Furthermore, in the composite laminate 12 of the embodiment, an electronic device is formed by an electronic component 6 being mounted on the first metal layer 1.

The first metal layer 1 contains copper. The first metal layer 1, for example, is used as a circuit conductor. Furthermore, the first metal layer 1 is not limited to a circuit conductor, and can also be used as a metal member for mounting the electronic components mounted on the composite laminate 12, and as a metal member for a ground conductor or as a heat radiating plate. Consequently, the first metal layer 1, for example, is used as either a conducting path for carrying a relatively large current of around several tens of A, or as a heat radiating material.

In this case, there is the possibility of the brazing material that joints the two members peeling from the first metal layer 1 and/or cracks forming in the brazing material due to the thermal stress caused by the difference in the coefficient of thermal expansion between the fourth layer 4 and the first metal layer 1, and to prevent this, the composite laminate 12 constitutes the following configuration.

That is, the composite laminate 12 of this embodiment is formed by the first metal layer 1, the second metal layer 2, the third metal layer 3, and the fourth layer being sequentially laminated in a vertical direction (the direction of the z-axis). The second metal layer 2 is disposed on the lower surface of the first metal layer 1, the third metal layer 3 is disposed on the lower surface of the second metal layer 2, and the fourth layer 4 is disposed on the lower surface of the third metal layer 3.

The first metal layer 1, for example, is formed using one of copper and an alloy material having copper as the primary component. In the first metal layer 1, a metal material having high thermal conductivity is used from the point of view of the heat radiating properties, and it is preferable that copper, which is a high thermal conductivity metal material, be used (Cu thermal conductivity: 395 W/(m K)). In accordance with subjecting a Cu ingot (block) to machining processing, such as a rolling processing method or a punching processing method, or a metal working method like etching or some other such chemical processing, the Cu ingot is formed into a prescribed pattern having a flat plate shape that is from 10 to 300 µm thick.

The copper used in the first metal layer 1, for example, is oxygen-free copper. When oxygen-free copper is used as the material for the first metal layer 1, the joint strength between the first metal layer 1 and the fourth layer 4 is improved when jointing the first metal layer 1 to the fourth layer 4 because the oxidation of the surface of the copper because of oxygen existing inside the copper is reduced, and wettability with the jointing material 7 (described later) is improved.

The third metal layer 3 contains silver, at least one metal selected from a first group made up of Sn, Al and Ga, and at least one metal selected from a second group made up of In and Sb.

Furthermore, in the embodiment of the example illustrated in FIG. 1, the third metal layer 3 further contains at least one item from among Ti, Hf, and Zr. The first metal layer 1 is jointed to the fourth layer 4 using these active metals.

The thickness of the third metal layer 3, for example, should be around from 5 to 100 µm.

The second metal layer 2 contains an alloy that includes copper and at least one metal selected from a first group made up of Sn, Al, and Ga. The second metal layer 2 may be construed as an alloyed layer in which the copper included in the first metal layer 1 bonds with at least one metal selected from the first group, this metal having diffused from the third metal layer 3.

In this embodiment of the example illustrated in FIG. 1, the fourth layer 4 is a ceramic substrate. The fourth layer 4, for example, is made from a ceramic, such as an aluminum oxide-based ceramic, a mullite-based ceramic, a silicon carbide-based ceramic, an aluminum nitride-based ceramic, or a silicon nitride-based ceramic. Of these ceramic materials, the silicon carbide-based ceramic, the aluminum nitride-based ceramic, and the silicon nitride-based ceramic are preferable with respect to thermal conductivity, which affects the heat radiating properties, and one of the silicon nitride-based ceramic and the silicon carbide-based ceramic is preferable with respect to strength.

In a case where the fourth layer 4 is made from a ceramic material having relatively high strength like a silicon nitride-based ceramic, it is possible to realize a composite laminate 12 that can carry a larger current while being made smaller because the possibility of cracks forming in the fourth layer 4 is reduced even when a thicker first metal layer 1 is used.

As for the thickness of the fourth layer 4, thinner is better from the point of view of thermal conductivity, and, for example, this thickness should be approximately from 0.1 to 1 mm, and should be selected in accordance with either the size of the composite laminate 12, or the thermal conductivity or strength of the material used.

In a case where the fourth layer 4 is made from a silicon nitride-based ceramic, for example, the fourth layer 4 is produced by adding an appropriate organic binder, plasticizer, and solvent to a raw material powder, such as silicon nitride, aluminum oxide, magnesium oxide, or yttrium oxide, and mixing them together to form a slurry, and using a conventionally-known one of doctor blade method and calender roll method on the slurry to form a ceramic green sheet (ceramic raw sheet), then subjecting the ceramic green sheet to appropriate punching processing or the like to form a prescribed shape, laminating a plurality of sheets together as required to form a compact, and lastly firing the compact in a non-oxidizing atmosphere, such as a nitriding atmosphere, at a temperature of 1600 to 2000°C.

Furthermore, a plating method may be used to deposit a metal that is highly conductive and anti-corrosive, and has good wettability with the brazing material (jointing material 7 and the like) onto the first metal layer 1. In this case, the jointing of the first metal layer 1 with external electrical circuits, the jointing material 7 and the like can become easier and stronger. It also enables better electrical connections to be made between the first metal layer 1 and the external electrical circuits and the like.

As the plating metal, for example, a metal material such as nickel, cobalt, copper, or gold, or an alloy material having these metal materials as the primary components can be cited. For example, a plated layer of a nickel-phosphorus amorphous alloy containing between 8 to 15 mass % of phosphorus internally is preferable because it can suppress surface oxidation of the nickel plated layer and maintain the wettability of the jointing material 7 and the like for a long time. When the phosphorus content is around from 8 to 15 mass % relative to the nickel, the nickel-phosphorus amorphous alloy is easy to form, and the adhesive strength of the jointing material 7 and the like with respect to the plated layer can be improved. This nickel plated layer should be around from 1.5 to 10 µm thick, for example.

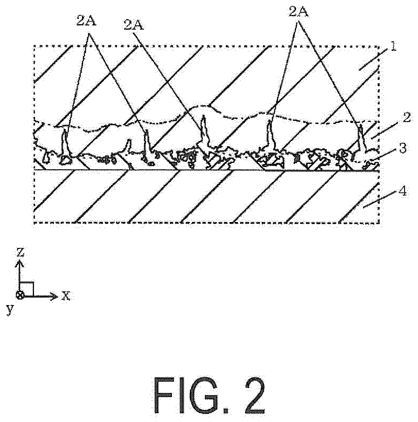

FIG. 2 is an enlarged view of portion A of FIG. 1. As in the example illustrated in FIG. 2, the third metal layer 3 has a metal portion 2A that partially penetrates the second metal layer 2 from the third metal layer 3. Consequently, a substantial anchor effect can be achieved between the second metal layer 2 and the third metal layer 3. Thus, internal inter-layer peeling can be suppressed because the third metal layer 3 is firmly jointed to the first metal layer 1.

In the example illustrated in FIG. 2, the width of the metal portion 2A is approximately from 20 to 100 µm. The length of the metal portion 2A is approximately from 50 to 150 µm. Furthermore, a plurality of metal portions 2A is provided.

The third metal layer 3 is a joint layer that joints the first metal layer 1 to the fourth layer 4. Thus, the third metal layer 3 contains silver, at least one metal selected from the first group made up of Sn, Al, and Ga, which function as the brazing material, and at least one metal selected from the second group made up of In and Sb. For example, the third metal layer 3 is a tin-silver brazing material.

To make the joint between the first metal layer 1 and the fourth layer 4 via the third metal layer 3 that serves as this brazing material stronger, the second metal layer 2 is disposed as an alloy layer between the first metal layer 1 and the third metal layer 3.

Furthermore, the metal portion 2A that is made from an alloy of Ag and at least one metal selected from the second group made up of In and Sb partially penetrates the second metal layer 2. For example, the metal portion 2A includes an Ag-In alloy.

It is preferable that the alloy of Ag and the second group metal account for from 70 to 100% of the metal portion 2A as a whole. Furthermore, in a case where the alloy of Ag and the second group metal in the metal portion 2A accounts for from 70 to 100% of the metal portion 2A as a whole, the remaining approximately from 0 to 30% of the surface area is accounted for by Ag alone, an Ag-In-Sn alloy, an Ag-Sn alloy, an In-Sn alloy or the like.

When calculating the cross-sectional area accounted for by the alloy, first, the elements of a cross-section of the metal portion 2A are mapped using wavelength-dispersive X-ray spectroscopy (WDS). Then, for example, the cross-sectional area of the alloy is calculated by calculating the area of a region where the Ag and the second group metal overlap. Further, when calculating the cross-sectional area accounted for by a simple metal, the area of the region that does not overlap with another element should be calculated.

A substantial anchor effect can be achieved between the first metal layer 1 and the third metal layer 3 because a metal portion 2A partially penetrates the second metal layer 2 in an intricate configuration like that illustrated in FIG. 2, for example. The first metal layer 1 and the third metal layer 3 are firmly jointed to one another by this anchor effect.

Furthermore, the third metal layer 3 in the example of FIG. 2 constitutes a configuration in which the crystal grains of a silver-based alloy such as silver-copper are dispersed inside a silver matrix. That is, the third metal layer 3 as a whole does not constitute a substantially uniform composition, but rather a metal component such as copper, which is a diffusion component from the first metal layer 1, is unevenly distributed in portions. The third metal layer 3 may include a portion in which a portion of the components are unevenly distributed like this.

The jointing of the first metal layer 1 to the fourth layer 4 is performed using a brazing material. In this case, for example, the first metal layer 1 is positioned and temporarily fixed to the upper surface of the fourth layer 4 via a brazing material layer, and thereafter, the first metal layer 1 is jointed to the fourth layer 4, for example, by integrally heating these layers in an electric furnace followed by cooling.

The brazing material used in this case is the third metal layer 3. A specific composition of the brazing material that constitutes the third metal layer 3, for example, includes the following. That is, the brazing material is from 30 to 70 mass % of Ag, from 1 to 5 mass % of Ti, from 20 to 40 mass % of at least one metal selected from the first group, and from 1 to 40 mass % of at least one metal selected from the second group. A more specific example can be given as 69 mass % of Ag, 1 mass % of Ti, 20 mass % of Sn, and 10 mass % of In.

The third metal layer 3 may contain around from 1 to 20 mass % of copper or the like in addition to the aforementioned metal components.

In the process of producing the composite laminate 12 of the present invention, for example, as the metal material (brazing material) that constitutes the third metal layer 3, from 20 to 40 mass % of at least one metal selected from the first group, and at least one metal selected from the second group are added to a brazing material that has silver as its primary component so that the melting point of the brazing material becomes approximately 600°C.

The example described above, for example, can be given as the composition in this case. The first metal layer 1 and the fourth layer 4 are made to face one another and temporarily fixed with this brazing material (the third metal layer 3) therebetween, and is subjected to thermal treatment, for example, at a temperature that is 50°C higher than the aforementioned melting point, or at an even higher temperature. In a case where the temperature of the thermal treatment is set near the aforementioned melting point, the thermal treatment time period is set, for example, at one hour or longer.

Because the brazing material (third metal layer 3) here contains a first group metal at a high concentration of 20 to 40 mass %, the second metal layer 2 is formed by the first group metal reacting with the copper in the first metal layer 1 during the aforementioned thermal treatment. During the reaction, the hardness of the second metal layer 2 is low, and therefore the metal portion 2A of silver and a second group metal that was formed in the third metal layer 3 easily extends into the second metal layer 2. Accordingly, as illustrated in FIG. 2, the metal portion 2A is able to penetrate the second metal layer 2 in an intricate configuration. Furthermore, the shape of the metal portion 2A in the example illustrated in FIG. 2 is an example of a case where the first group metal contained in the brazing material is equal to or greater than 20 mass % but less than 30 mass %.

Furthermore, in a case where the first metal layer 1 is used as a circuit conductor, the first metal layer 1 must be processed in a prescribed circuit conductor pattern (what is called patterning). In this case, for example, the first metal layer 1, which has been subjected to prescribed patterning beforehand, is laminated as a circuit conductor, and then brazing (firing) can be performed via the brazing material.

Furthermore, the processing of this metal plate into a prescribed circuit pattern may be done after the first metal layer 1 has been jointed to the fourth layer 4.

Etching processing that is used together with masking can be given as a specific patterning method for the first metal layer 1. Ferric chloride is used in the etching of Cu (the first metal layer 1).

The composite laminate 12 is fabricated as described above. The composite laminate 12, for example, is used as a substrate for mounting an electronic component 6. Furthermore, in the example of FIG. 1, the first metal layer 1 is jointed to each of the two main surfaces (upper and lower surfaces) of the fourth layer 4. The electronic component 6 is mounted on the middle metal plate of the three metal plates jointed to the upper surface of the fourth layer 4, and the electronic component 6 is electrically connected to the two metal plates on the left and right.

The electronic component 6, for example, is a semiconductor element, such as a transistor, a large scale integrated circuit (LSI) for a central processing unit (CPU), an insulated gate bipolar transistor (IGBT), or a metal oxide semiconductor-field effect transistor (MOS-FET). The electronic component 6, for example, is jointed to the upper surface of a portion of the first metal layer 1 using a jointing material 7 made from either a metal or a conductive resin or the like. The jointing material 7, for example, is a solder, a gold-tin (Au-Sn) alloy, or a tin-silver-copper (Sn-Ag-Cu) alloy. In this case, of the first metal layers 1, the one to which the electronic component 6 is jointed functions as a heat radiating plate for radiating heat generated by an electronic element 2 mounted on the first metal layer 1.

Furthermore, a portion of the first metal layer 1 is electrically connected to the electronic component 6 via conductive connecting material 8 such as a bonding wire. These first metal layers 1 function as circuit conductors, and electrically connect the electronic component 6 to an external electrical circuit (not illustrated in the drawing).

### Second embodiment (according to the invention)

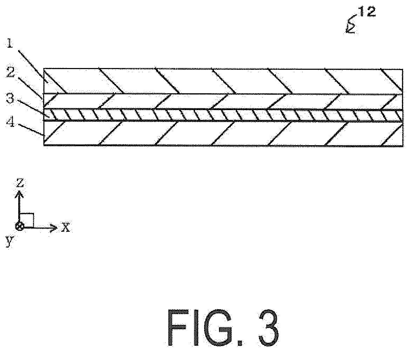

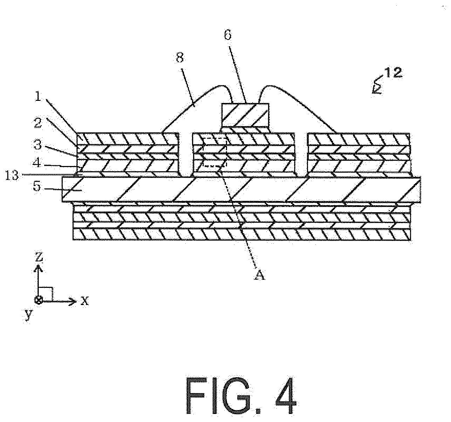

Next, a second embodiment will be explained using FIGS. 3 and 4. Unlike the first embodiment, in this embodiment, a metal layer with a lower coefficient of thermal expansion than that of the first metal layer 1 is used as the fourth layer 4. In addition, members that have the same reference numbers as those of the first embodiment are regarded as the same members as the first embodiment.

In the example illustrated in FIG. 3, the composite laminate 12 according to this embodiment includes a first metal layer 1, a second metal layer 2, a third metal layer 3, and a fourth layer 4.

Furthermore, in the example illustrated in FIG. 4, the fourth layer 4 of the composite laminate 12 is jointed to a fifth layer 5, which is a ceramic substrate. In this case, the thermal stress generated at an interface portion between the first metal layer and the fifth layer 5 is effectively reduced by jointing the fourth layer 4 of the composite laminate 12 to the fifth layer 5. Consequently, it is possible to suppress the occurrence of a mechanical breakdown such as crack in the fifth layer 5.

Furthermore, because the fourth layer 4 has a lower Young's modulus and higher toughness than that of the fifth layer 5, for example, thermal stress can be relieved by the deformation of the fourth layer 4 itself. Thus, a mechanical breakdown such as a crack is effectively suppressed in the fourth layer 4.

The fourth layer 4, which is for suppressing the thermal expansion of the first metal layer 1, is made from a metal material such as molybdenum (Mo), tungsten (W), or an iron-nickel (Fe-Ni) alloy such as Invar with a lower coefficient of thermal expansion than that of Cu, and is formed into a prescribed pattern having a flat plate shape that is from 5 to 300 µm thick using the same method as that for the first metal layer 1.

The coefficient of thermal expansion of the first metal layer 1 and the coefficient of thermal expansion of the fourth layer 4 should be construed as being the physical property value of the metal material constituting the primary component. The primary component may be construed as being the material that accounts for 50 mass % or greater.

Furthermore, the third metal layer 3 contains Ti. Ti, which is an active metal, is firmly jointed to the first metal layer 1 and the fourth layer 4. The third metal layer 3 is firmly jointed to the fourth layer 4 via this active metal. Joint strength is thus enhanced further. Therefore, mechanical breakdowns such as inter-layer peeling are more effectively suppressed in the composite laminate 12.

The jointing of the fourth layer 4 to the fifth layer 5, for example, is performed by brazing using a brazing material 13 that includes silver and Ti. In this case, for example, a laminate of the first metal layer 1 to the fourth layer 4 is positioned and temporarily fixed via a layer of the brazing material 13 on the upper surface of the fifth layer 5, and thereafter, the laminate is jointed to the fifth layer 5, for example, by integrally heating these laminated layers in an electric furnace followed by cooling.

The brazing material 13 in this case is a silver brazing material that includes Ti, which is an active metal, and in addition to the laminate (in actuality, the fourth layer 4), is also firmly jointed to the fifth layer 5, which is made from a ceramic. Therefore, the fourth layer 4 is firmly jointed to the fifth layer 5, and, for example, even when thermal stress caused by a difference in thermal expansion between the first metal layer 1 and the fifth layer 5 occurs, the peeling of the laminate from the fifth layer 5 due to this thermal stress is effectively suppressed.

The same as in the case of the third metal layer 3, the crystals of the silver-based alloy may be unevenly distributed inside the brazing material 13 as well. A silver-indium alloy, and an alloy of silver and Ti can be given as the silver-based alloy in the brazing material 13.

Furthermore, as for the jointing of the first metal layer 1 through the fourth layer 4 to the fifth layer 5, after having produced a laminate that joints the first metal layer 1 through the fourth layer 4 to one another, this laminate may be jointed to the fifth layer 5, or the jointing of the first metal layer 1 through the fourth layer 4 to the fifth layer 5 may be performed at the same time. In a case where the jointing of the first metal layer 1 through the fourth layer 4 to the fifth layer 5 is performed at the same time, the jointing (brazing) is performed only one time, thereby enabling productivity to be further enhanced. In this case, the brazing material components may be adjusted so that the brazing material 13 changes from a liquid phase to a solid phase in order from the vicinity of the fifth layer 5, and firing may be performed while applying pressure to the laminate of the first metal layer 1 through the fourth layer 4 and the fifth layer 5.

Specific etching processing, for example, is as follows.

That is, etching of the Cu (the first metal layer 1) is performed using ferric chloride, etching of the brazing material joint part (the third metal layer 3) is performed using nitrohydrofluoric acid, and when the low thermal expansion material (the fourth layer 4) is Mo, etching is performed using an oxidative acidic liquid of hydrochloric acid, sulfuric acid, and water in a volume ratio of 1:1:3. When the fourth layer 4 (the low thermal expansion material) is made from Invar, ferric chloride and the like is used. Also, when the fourth layer 4 is made from W/Mo (an alloy), an alkaline solution that includes ferricyanic acid is used.

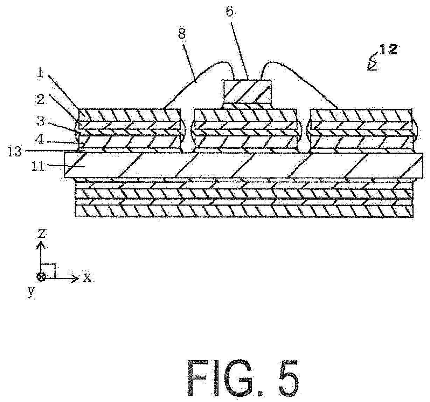

FIG. 5 is a cross-sectional view illustrating a modification example of the composite laminate 12 illustrated in FIG. 4 and an electronic device that makes use thereof. In FIG. 5, the same reference numbers are given to members that are the same as those in FIG. 4. In the example of FIG. 5, the third metal layer 3 is larger in size than that of the first metal layer 1 and the fourth layer 4 in the plan view. In other words, the peripheral position of the third metal layer 3 is more towards the outside than the positions of the peripheries of the first metal layer 1 and the fourth layer 4. Consequently, the third metal layer 3 is attached by extending the peripheral portion thereof to the outer side faces of the first metal layer 1 and the fourth layer 4.

In a case like this, the joint area of the third metal layer 3 becomes larger relative to the first metal layer 1 and the fourth layer 4. Also, in the peripheral portion of the third metal layer 3, the joint portion relative to the outer side faces of the first metal layer 1 and the fourth layer 4 intersects with the direction acted on by thermal stress occurring between the first metal layer 1 and the fourth layer 4. Thus, in this case, the reliability of the joint between the first metal layer 1 and the fourth layer 4 via the third metal layer 3 can be improved.

A structure like this, for example, makes it possible to adjust the volume of the third metal layer 3 and to form the third metal layer 3 so that a part thereof extends to the outer side face of the first metal layer 1 and the fourth layer 4 when jointing the first metal layer 1 and the fourth layer 4 via the third metal layer 3. Also, the brazing material produces a meniscus at the peripheral edge where the first metal layer 1 joints with the third metal layer 3, and stress focused on the joint part is dispersed when this meniscus forms an R shape.

Furthermore, in a case where the composite laminate 12 is used as a circuit conductor, there is the possibility of the third metal layer 3 expanding to the main surface of the circuit conductor when the volume of the third metal layer 3 is too large. In this case, there is the possibility that circuit substrate characteristics, such as the bonding property of the bonding wire (conductive connecting material 8), will be degraded with respect to the circuit conductor. Therefore, it is preferable that the volume of the third metal layer 3 that extends to the outer side faces of the first metal layer 1 and the fourth layer 4 be suppressed to around the thickness of the first metal layer 1 and the fourth layer 4 or less.

### Third Embodiment (not according to the invention)

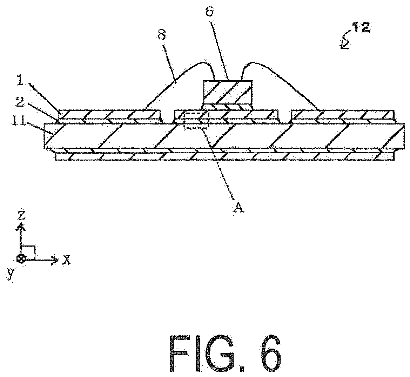

Next, a third embodiment will be explained using FIGS. 6 to 8. Unlike the first embodiment, a third metal layer 3 is not provided in this embodiment. Members that have the same reference numbers as those of the first and second embodiments are regarded as the same members as the first and second embodiments.

In the example illustrated in FIG. 6, the composite laminate 12 includes a first metal layer 1, a second metal layer 2, and a third layer 11. The second metal layer 2 is arranged on the lower surface of the first metal layer 1, and the third layer 11 is arranged on the lower surface of the second metal layer 2. The first metal layer 1 is the same as that used in the first embodiment. As with the first embodiment, the second metal layer 2 contains an alloy that includes copper and at least one metal selected from a first group made up of Sn, Al, and Ga.

Furthermore, in the example illustrated in FIG. 6, the third layer 11 is the same ceramic substrate as the fourth layer 4 that is explained in the first embodiment.

Furthermore, as with the fourth layer 4 explained in the second embodiment, the third layer 11 may be a metal layer with a lower coefficient of thermal expansion than that of the first metal layer 1. In this case, like the example illustrated in FIG. 4, the third layer 11 is jointed to the ceramic substrate using a brazing material or other such jointing material.

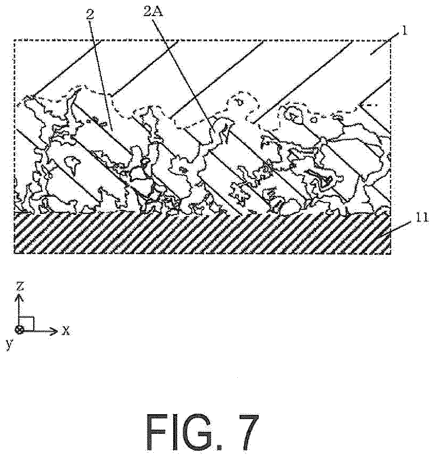

FIG. 7 is an enlarged view of portion A in FIG. 6. In the example illustrated in FIG. 7, a metal portion 2A that partially penetrates the second metal layer 2 from the third layer 11 side is disposed in the second metal layer 2. Consequently, an anchor effect can be achieved between the second metal layer 2 and the third layer 11 via the metal portion 2A. Thus, internal inter-layer peeling can be suppressed because the third layer 11 is firmly jointed to the first metal layer 1.

Furthermore, in the example illustrated in FIG. 7, the metal portion 2A constitutes an intricately intertwined three-dimensional net structure. Accordingly, the anchor effect between the second metal layer 2 and the third layer 11 can be further improved because the metal portion 2A is disposed inside the second metal layer 2 in a more complex shape.

This metal portion 2A contains silver, at least one metal selected from a first group made up of Sn, Al, and Ga, and at least one metal selected from a second group made up of In and Sb.

In order to produce a metal portion 2A like this example, a brazing material containing silver, at least one metal selected from a first group made up of Sn, Al, and Ga, and at least one metal selected from a second group made up of In and Sb, and having a first group metal content of around from 30 to 40 mass % is used. By arranging this brazing material between the first metal layer 1 and the third layer 11 and performing brazing, the second metal layer 2, in which the first group metal included in the brazing material and the copper included in the first metal layer 1 are bond to form an alloy, is formed, and the metal portion 2A is formed inside the second metal layer 2 by the components in the brazing material being diffused in a direction away from the third layer 11.

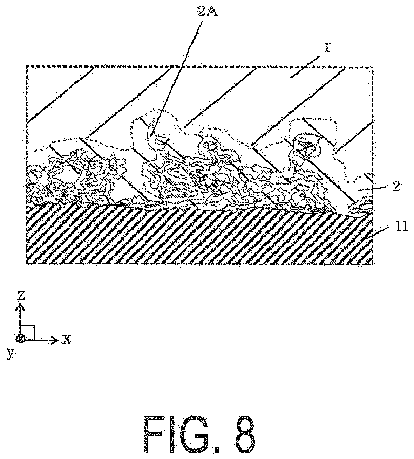

FIG. 8 is an enlarged view of a modification example of portion A in FIG. 6. In the example illustrated in FIG. 8, a high anchor effect can be achieved because a metal portion 2A constitutes an intricately intertwined string-like three-dimensional net structure.

In order to produce a metal portion 2A like this example, a brazing material containing silver, at least one metal selected from a first group made up of Sn, Al, and Ga, and at least one metal selected from a second group made up of In and Sb, and having a first group metal content of around from 20 to 40 mass % and a second group metal content of around from 30 to 40 mass % is used. By arranging this brazing material between the first metal layer 1 and the third layer 11 and performing brazing, the second metal layer 2, in which the first group metal included in the brazing material and the copper included in the first metal layer 1 are bond to form an alloy, is formed, and the metal portion 2A is formed inside the second metal layer 2 by the components in the brazing material being diffused in a direction away from the third layer 11.

### Reference Number

- 1: First metal layer
- 2: Second metal layer
- 2A: Metal portion
- 3: Third metal layer
- 4: Fourth layer
- 5: Fifth layer
- 6: Electronic component
- 7: Jointing material
- 8: Conductive connecting material
- 11: Third layer
- 12: Composite laminate

## Claims

1. A composite laminate, comprising:
a first metal layer containing copper;
a second metal layer arranged on a lower surface of the first metal layer;
a third metal layer that is arranged on a lower surface of the second metal layer, and contains silver, at least one metal selected from a first group made up of Sn, Al, and Ga, and at least one metal selected from a second group made up of In and Sb; and
a fourth layer arranged on a lower surface of the third metal layer;
wherein the third metal layer contains a metal portion that partially penetrates the second metal layer,
wherein the first metal layer is jointed to the fourth layer by a brazing material that constitutes the third metal layer and contains from 30 to 70 mass % of Ag, from 1 to 5 mass % of Ti, from 20 to 40 mass % of at least one metal selected from the first group, and from 1 to 40 mass % of at least one metal selected from the second group,
wherein the fourth layer is a metal layer with a lower coefficient of thermal expansion than that of the first metal layer, and
wherein the composite laminate further comprises a fifth layer that is a ceramic substrate, wherein the fourth layer is jointed to the fifth layer.

2. The composite laminate according to claim 1, wherein the metal portion contains an Ag-In alloy.

3. The composite laminate according to any of claims 1 to 2, wherein the fourth layer contains Mo as a primary component.

4. An electronic device, comprising:
the composite laminate described in any of claims 1 to 3; and
an electronic component mounted to the composite laminate.

## Patentansprüche

1. Verbundlaminat, aufweisend:
eine erste Metallschicht, die Kupfer enthält,
eine zweite Metallschicht, die auf einer unteren Fläche der ersten Metallschicht angeordnet ist,
eine dritte Metallschicht, die auf einer unteren Fläche der zweiten Metallschicht angeordnet ist und Silber, mindestens ein Metall, ausgewählt aus einer ersten Gruppe bestehend aus Sn, Al und Ga, und mindestens ein Metall, ausgewählt aus einer zweiten Gruppe bestehend aus In und Sb, enthält, und
eine vierte Schicht, die auf einer unteren Fläche der dritten Metallschicht angeordnet ist,
wobei die dritte Metallschicht einen Metallabschnitt enthält, der teilweise in die zweite Metallschicht eindringt,
wobei die erste Metallschicht mit der vierten Schicht durch ein Lötmaterial verbunden ist, das die dritte Metallschicht bildet und 30 bis 70 Masse-% Ag, 1 bis 5 Masse-% Ti, 20 bis 40 Masse-% mindestens eines Metalls, ausgewählt aus der ersten Gruppe, und 1 bis 40 Masse-% mindestens eines Metalls, ausgewählt aus der zweiten Gruppe, enthält,
wobei die vierte Schicht eine Metallschicht mit einem niedrigeren Wärmedehnungskoeffizienten als dem der ersten Metallschicht ist, und
wobei das Verbundlaminat ferner eine fünfte Schicht aufweist, die ein Keramiksubstrat ist, wobei die vierte Schicht mit der fünften Schicht verbunden ist.

2. Verbundlaminat gemäß Anspruch 1, wobei der Metallabschnitt eine Ag-In-Legierung enthält.

3. Verbundlaminat gemäß irgendeinem der Ansprüche 1 bis 2, wobei die vierte Schicht Mo als eine Primärkomponente enthält.

4. Elektronische Vorrichtung, aufweisend:
das in irgendeinem der Ansprüche 1 bis 3 beschriebene Verbundlaminat und
ein elektronisches Bauelement, das an dem Verbundlaminat montiert ist.

## Revendications

1. Stratifié composite, comprenant :
une première couche de métal contenant du cuivre,
une deuxième couche de métal disposée sur une surface inférieure de la première couche de métal,
une troisième couche de métal disposée sur une surface inférieure de la deuxième couche de métal et contenant de l'argent, au moins un métal choisi dans un premier groupe constitué par Sn, Al et Ga, et au moins un métal choisi dans un deuxième groupe constitué par In et Sb, et
une quatrième couche disposée sur une surface inférieure de la troisième couche de métal,
où la troisième couche de métal contient une partie de métal qui pénètre partiellement dans la deuxième couche de métal,
la première couche de métal étant reliée à la quatrième couche par un matériau de brasage constituant la troisième couche de métal et contenant de 30 à 70 % en masse d'Ag, 1 à 5 % en masse de Ti, 20 à 40 % en masse d'au moins un métal choisi dans le premier groupe, et 1 à 40 % en masse d'au moins un métal choisi dans le deuxième groupe,
où la quatrième couche est une couche de métal ayant un coefficient de dilatation thermique inférieur à celui de la première couche de métal, et
où ledit stratifié composite comprend en outre une cinquième couche qui est un substrat céramique, ladite quatrième couche étant liée à ladite cinquième couche.

2. Stratifié composite selon la revendication 1, dans lequel la partie de métal comprend un alliage Ag-In.

3. Stratifié composite selon l'une quelconque des revendications 1 à 2, dans lequel la quatrième couche contient Mo comme composant primaire.

4. Dispositif électronique, comprenant :
le stratifié composite décrit dans l'une quelconque des revendications 1 à 3, et
un composant électronique monté sur le stratifié composite.
